Europäisches Patentamt

European Patent Office

Office européen des brevets

(11) Publication number: **0 466 989 A2**

# EUROPEAN PATENT APPLICATION

(21) Application number: **90314139.8**

(22) Date of filing: **21.12.90**

(51) Int. Cl.5: **G10K 11/16**

(30) Priority: **19.07.90 US 554453**

(43) Date of publication of application:
**22.01.92 Bulletin 92/04**

(84) Designated Contracting States:
**AT BE CH DE DK ES FR GB GR IT LI LU NL SE**

(71) Applicant: **BOOZ-ALLEN & HAMILTON, INC.**
**4330 East West Highway**
**Bethesda, Maryland 20814(US)**

(72) Inventor: **Balestri, Robert**
**212 Bookham Lane**
**Gaithersburg, Maryland 20877(US)**
Inventor: **Rich, W. Foster**
**3823 N. Tazewell Street**
**Arlington, Virginia 22207(US)**
Inventor: **Eng, Stephen M. L.**
**2114 Robin Way Court**
**Vienna, Virginia 22180(US)**
Inventor: **Lezec, Robert B.**
**3537 Sheffield Manor Terr., Apt. 402**
**Silver Spring, Maryland 20904(US)**
Inventor: **Pagliuca, Joseph P.**
**15746 Millbrook Lane**
**Laurel, Maryland 20707(US)**

(74) Representative: **Tomlinson, Kerry John et al**
**Frank B. Dehn & Co. European Patent**
**Attorneys Imperial House 15-19 Kingsway**
**London WC2B 6UZ(GB)**

(54) **System and method for predicting signals in real time.**

(57) A system is disclosed for predicting and modifying broadband periodic and aperiodic signals in real time. A signal to be predicted is detected and successively sampled over time and stored. An adaptive filter (28) predicts a next successive signal based on the sum of a predefined number of stored, successive samples(50). Each one of the stored samples is multiplied by a corresponding filter coefficient (61). The predicted signal generated by the adaptive filter is used to modify or cancel the detected signal. A residual error (e(n)) is determined from the predicted signal and the detected signal. The filter coefficients are modified(70) based on the residual error and the energy (E) of the stored signal samples.

EP 0 466 989 A2

The present invention relates generally to prediction systems for predicting signals in real time. More particularly, the present invention relates to a prediction system that may be used for real time cancellation or modification of broadband periodic as well as aperiodic signals.

In many environments, it is desirable, in fact necessary, to reduce the amplitude of noise, vibrations, and/or other interfering signals. The prior art has attempted to accomplish this reduction using a variety of techniques, both passive and active.

Passive reduction or attenuation is generally accomplished by disposing one or more layers of barrier, absorbing, and/or damping materials between the source of the noise or vibration and the area where a reduced or attenuated noise level is desired. While effective in some situations, passive attenuation systems are often unsuitable for applications where size, weight, and/or cost considerations prevent the use of attenuating materials.

Other prior art techniques have focussed on active signal reduction techniques such as Active Noise Cancellation (ANC). Active Noise Cancellation has received a considerable amount of interest in a variety of signal cancellation applications, e.g., air ducts, exhaust fans, zonal quieting, head phones, vibration cancellation in structures, and echo cancellation in electronic signal communications. The active reduction of sound waves in the audible range is performed by processing the electrical cancellation signals at a rate greater than the rate of propagation of those sound waves in a particular propagation medium. In the time it takes for a sound wave to propagate from a location where the sound is measured to a second location where it may be cancelled, there is time to sample the sound wave signal, process that information in a processing circuit, and produce a signal to drive an actuator to introduce a cancelling signal $180°$ out-of-phase and equal in amplitude to the propagating sound wave.

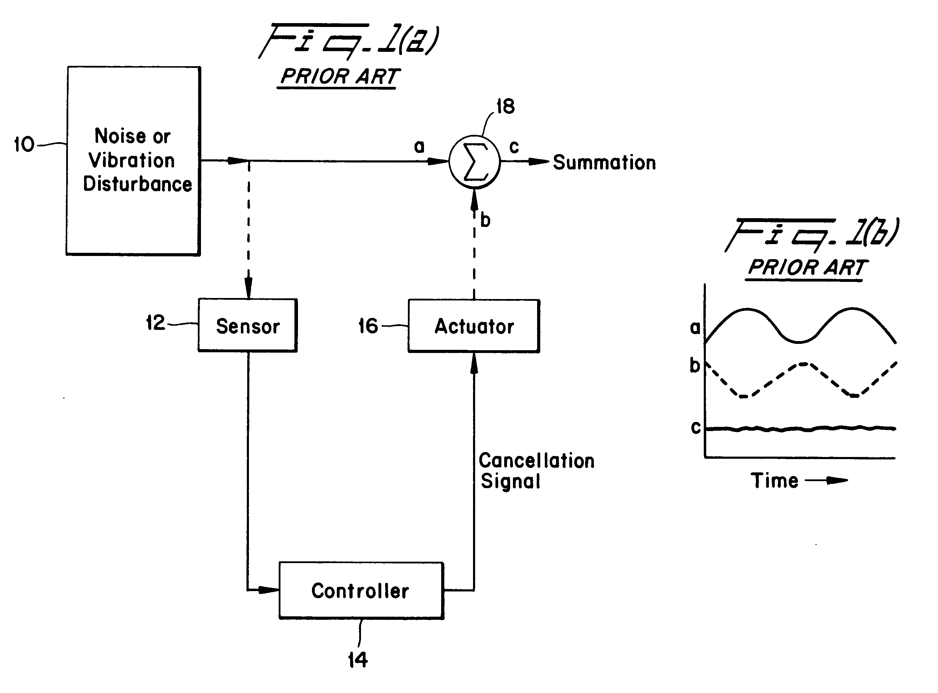

The function block diagram shown in Fig. 1(a) is useful in explaining basic principles of active noise cancellation systems or vibration cancellation systems. A noise or vibrational disturbance 10 is detected by a suitable sensor 12. The sensor 12 converts the noise or vibration 10 into an electrical signal which is processed in some fashion in a controller 14. The controller 14 determines a cancellation signal, typically the inverse of the sensed noise or vibration signal, and uses this cancellation signal to drive an actuator 16. In the case of acoustic noise, the actuator 16 is simply a speaker. If the cancellation is appropriately timed, the original noise signal is cancelled by an output signal generated by the actuator 16. This cancellation is represented mathematically as a summation of the sensed and cancellation signals at a summer 18.

A graphic depiction of the cancellation process is provided in Fig. 1(b). The noise signal represented by a waveform signal "a" is essentially cancelled by another waveform signal "b" of equal amplitude but having a phase difference of $180°$. The sum of these two waveforms leaves only a residual signal "c".

Systems for actively cancelling repetitive noise and vibration have been proposed for example in Chaplin, U.S. Patent Nos. 4,153,815; 4,490,841 and 4,654,871; as well as Warnaka et al, U.S. Patent No. 4,562,589; and Ziegler, Jr., U.S Patent No. 4,878,188.

In U.S. Patent Nos. 4,153,815 and 4,654,871, Chaplin describes the use of a synchronizing timing generator to provide cancellation of a repetitive noise. Initially, a noise or vibration signal is detected and analyzed so that a cancelling signal waveform can be generated. Once the cancelling waveform has been determined, a controller and pulse generators attempt to synchronize the timing of the cancellation signal so that the noise or vibration is cancelled. Any remaining noise is fed back to the controller as an error signal. The noise signal is divided into multiple intervals, and the amplitude of the cancelling signal is adjusted in each interval in response to the sign or amplitude of the error signal.

In U.S. Patent No. 4,490,841, Chaplin describes the use of Fourier transforms to process signals in the frequency domain. In this system, repetitive noise or vibration signals are cancelled by individually synchronizing the output of different frequency components of the cancelling signal based on a repetition rate sensed at the noise source. Fourier transforms are used to identify and quantify the discrete frequency components that contribute most significantly to the noise signal. These discrete frequency components are modified separately in order to adapt the cancelling waveform to the detected noise signals. The modified frequency components are inverse Fourier transformed back into the time domain to produce a cancellation signal for an output actuator.

The use of adaptive filters to accelerate the adaptation of active noise cancellation systems is suggested for example by Warnaka in U.S. Patent No. 4,562,589. Widrow et al., in "Adaptive Noise Cancelling Principles and Applications," Proceedings of IEEE, Vol. 63, No. 12, 12/75, pp. 1692-1716, uses a multiple weight, adaptive finite impulse response (FIR) filter to actively cancel noise signals. A previously determined, reference noise signal is used to tune or adapt the coefficients of the adaptive filter. The output signal from the filter is subtracted from the actual noise signal. Any detected residual noise or error is fed back to adjust the filter coefficients. A requirement of the Widrow system is that the reference signal be within $90°$ in-phase of the error signal.

A variation of the adaptive filter of the Widrow model is disclosed in the Ziegler, Jr. U.S. Patent No. 4,878,188. The adaptive filtering system includes for each frequency to be cancelled, a sine and cosine generator, responsive to a timing/synchronizing signal, for providing inputs to two adaptive filters whose outputs are summed to provide a cancellation signal.

Unfortunately, the prior art signal cancelling/reduction systems are complex, relatively slow, and inflexible. For example, most of the systems discussed above process signals in the frequency domain. As a result, three Fourier transformations must be calculated for each waveform: a first conversion of the detected signal into the frequency domain, a second conversion of the detected residual noise into the frequency domain, and a third conversion of the cancellation signal back into the time domain. Obviously, the computational time required to calculate these transformations is considerable.

Another deficiency of the prior art is the limited ability to adapt quickly to or predict changes in the character of the noise waveform. Undue reliance is placed on the assumption that the signal to be cancelled can be characterized as periodic or repetitive in nature. Thus, only those repetitive noises or vibrations that can be characterized and/or analyzed before the cancellation process begins, e.g., by using a reference or model noise signal, can be cancelled. Many of the prior art systems require timing and synchronization signals in order to accomplish noise cancellation. Aperiodic and/or random signals that cannot be predicted ahead of time cannot be cancelled effectively. Aperiodic signals are signals that do not repeat themselves at fixed intervals, but occur in unknown time and space intervals, e.g., a signal that has a random, time varying character.

Moreover, the prior art systems restrict their signal analysis either to a limited number of discrete periodic frequency components or to limited frequency bandwidths of the signal to be cancelled. This assumption is not acceptable in situations where the noise or vibration signals are not known in advance, where the frequency components of those signals vary over time, or where the frequencies of interest exceed the operating bandwidths of those systems.

Accordingly, there is a need for an adaptive signal prediction system that does not require conversions between the time and frequency domains, that does not require prior characterization or analysis of the signal to be cancelled or modified, that responds rapidly to changes in the character of the signal waveform, that does not require a synchronization signal, and that operates over a broad bandwidth of frequencies. In addition, such a system should be able to predict changes in aperiodic as well as periodic signals so that they may be cancelled or modified in real time.

A system and method are disclosed for predicting time varying signals in real time. A signal to be predicted is successively sampled over time. Based on the sum of a predefined number of stored, successive samples, a next successive signal is predicted. Each one of the stored samples is multiplied by a corresponding one of a plurality of coefficients. A residual error is determined from the predicted signal and the actual signal which was to be predicted. The coefficients are modified based on the residual error and the energy of the stored signal samples. The prediction system and method of the present invention is capable of predicting broadband and/or aperiodic signals for use in a wide variety of periodic applications.

An embodiment of the invention will now be described by way of example only and with reference to the accompanying drawings, in which:

Fig. 1(a) is a general schematic representation of an active noise cancellation system;

Fig. 1(b) is a graphic illustration of the active noise cancellation process;

Fig. 2 is a general functional schematic view of a system for implementing the present invention;

Fig. 3 is a more detailed functional schematic view of an adaptive filter for implementing the present invention;

Fig. 4 is a flow diagram for illustrating a control procedure for implementing the present invention;

Fig. 5(a) is a two-dimensional, graphical analysis of an application of the present invention to cancelling noise from a lawnmower; and

Fig. 5(b) is a three-dimensional graphical analysis of the two-dimensional graph shown in Fig. 5(a).

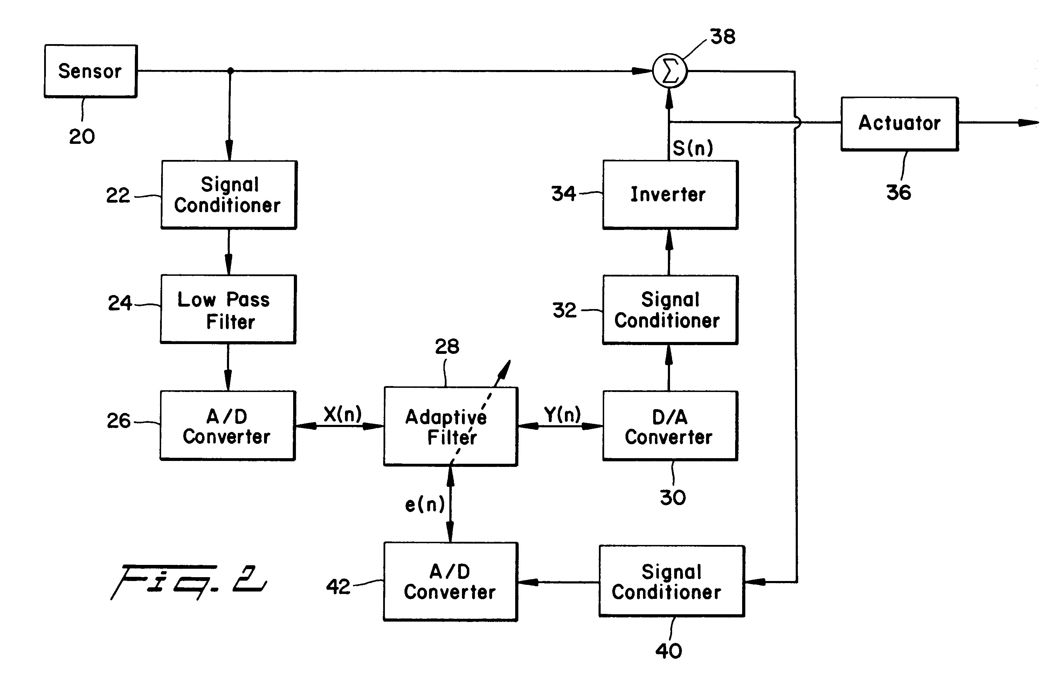

A general schematic of a system for implementing the present invention is shown in Fig. 2. Although the present invention is described for purposes of illustration in the context of signal cancellation applications, it will be appreciated that specific applications of the present invention are not limited to the cancellation of noise or vibration signals. Rather, the present invention is applicable to any situation where it is desirable to predict the behavior of a time varying signal. For example, the predicted signal may be used to perform some type of modification to the detected signal in real time. The term "real time" is defined as the capability of performing some action with respect to the predicted signal, for example, calculating and outputting a modifying or a cancellation signal, based on a current sampling of signals, prior to the next, successive sampling of the signal to be predicted. Other applications might include predicting signal behavior so that some action or event, e.g., sounding an alarm or actuating a switch, may take place in real time.

Initially, a sensor 20 is used to detect an applied force, typically a noise or vibration, and convert it to a measurable electrical signal. The sensor 20 might be, for example, a microphone, an accelerometer, a pressure sensor, a piezoelectric device, a geophone, a hydrophone, a surface acoustic wave (SAW) device, or the output of an electronic mixing circuit. The sensed signal is received by a signal conditioner 22 that adjusts the signal amplitude of the sensed signal to a range suitable for analog-to-digital conversion. For example, a suitable amplitude range might be 10 volts, peak-to-peak.

Once the sensed signal has been conditioned in the signal conditioner 22, it is filtered in a low pass filter 24. The low pass filter 24 eliminates the spectral content of the signal at frequencies higher than those frequencies of interest. The signal conditioner 22 and the low pass filter 24 may be implemented using an operational amplifier circuit (OP AMP). The output signal from the low pass filter is sampled using an analog-to-digital converter 26 (A-to-D) that has a dynamic range and sampling rate matched to the applicable digital signal processing circuitry. The analog-to-digital converter 26 samples the signal at a rate which specifies a particular number of samples/second.

The signal conditioner 22 and the low pass filter 24 prepare the sensed signal for sampling by the analog-to-digital converter 26. For example, suppose an application of the present invention is to cancel signals in a frequency band of 20 to 8,000 Hz. Since the highest frequency of interest in this example is 8 kHz, the cutoff frequency of the low pass filter 24 would be 8 kHz. In practice, it has been determined empirically that a sampling rate of five times the cutoff frequency of the low pass filter achieves accurate and stable results. In the example above, the sampling rate would need to be 40 kHz. As long as these criteria are met, an analog signal can be reconstructed satisfactorily from a set of uniformly spaced, discrete samples in time. Obviously, the greater the sampling rate of the analog signal, the more accurate the reconstruction of the signal.

Unfortunately, in reconstruction of the sensed signal, frequency components originally located above one-half of the sampling rate appear below this point and are passed by the low pass filter. This phenomenon is known as aliasing and results in distortion of the sensed signal. The effects of aliasing can be significantly reduced by narrowly defining the frequency band that is to be passed by the filter 24 before sampling occurs in the A-to-D converter 26. Consequently, the signal conditioner 22 and the low pass filter 24 should be designed to the frequency band most suitable for the particular application involved.

Returning to Fig. 2, the digitized samples generated by the A-to-D converter 26 are received in an adaptive filter 28. The signal processing performed by the adaptive filter 28 may be implemented using a conventional, floating point microprocessor, such as model TMS320C30 manufactured by Texas Instruments, Inc. The microprocessor should have a dynamic range of at least 12 bits and a sampling capability of at least 20 kHz. The adaptive filter 28 is a least mean squares (LMS) digital filter. In general, the LMS adaptive filter 28 sequentially predicts the next, successively sampled signal based on the previously known samples. The specific implementation and functions of the adaptive filter 28 are described in more detail below. The output signal generated by the adaptive filter 28 is converted back into analog form in a digital-to-analog converter 30. The analog signal generated by the D-to-A converter 30 is amplified to a suitable level in a signal conditioner 32, similar to the signal conditioner 22. The conditioned analog signal is then processed in an inverter 34. The inverted output signal is used to drive an actuator 36 which generates a cancelling signal. The actuator 36 can be, for example, a loudspeaker, headphone or other acoustic actuator, an electromechanical, electrohydraulic, piezoelectric or other vibration actuator, or an electronic mixing circuit.

The inverted signal is also combined with the sensed signal and summed in a summing means 38 in order to generate a residual error signal. The residual error signal represents the degree to which the predicted signal differs from the physical signal present at that time in the environment. The environment is defined as the medium in which the signal to be predicted is present. The residual error signal is processed in a signal conditioner 40 and sampled by an A-to-D converter 42 similar to the signal conditioner 22 and the A-to-D converter sampler 26, respectively. The digitized error is used in the adaption of the adaptive filter weights, as will be described in more detail below, in an attempt to drive the residual error signal to zero.

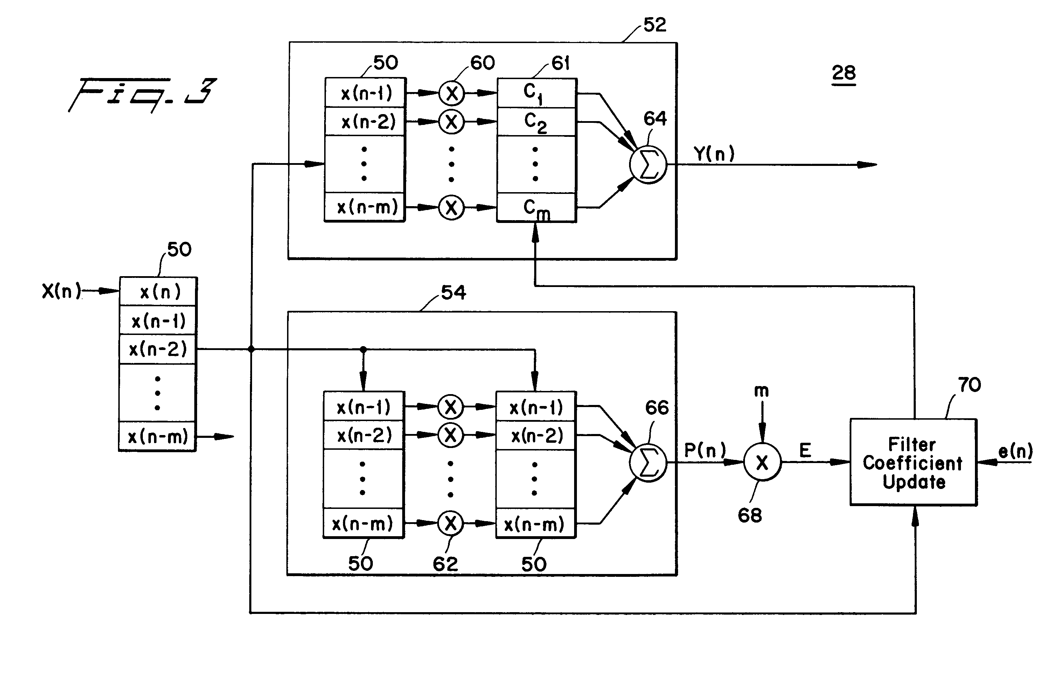

Further description of the adaptive filtering process carried out in the adaptive filter 28 will be described in conjunction with Fig. 3. A current signal sample X(n), sampled by the A-to-D converter 26 at time n, is stored in a memory 50. In the preferred embodiment of the invention, the memory 50 is arranged in a first-in-first-out (FIFO) stack. In this arrangement, m successive signal samples may be stored sequentially in the stack. The number of samples m may be any suitable integer number, and in many applications, a suitable value is m = 5. For purpose of simplifying the description only, the FIFO memory stack 50 has been depicted in various locations where the stored signal samples are required for a particular operation. In actuality, only one memory stack is required. When the current sample X(n) is pushed onto the FIFO stack 50 at time n, the oldest sample X(n-m) is pushed out of the stack.

Each sample stored in the FIFO stack 50 is input to a digital filter 52 and is multiplied by a corresponding filter coefficient, weight, or tap ($C_1$, $C_2$, . . . $C_m$) via multipliers 60. The individual products of each sample and its corresponding filter coefficient are summed in a summing device 64 to generate a predicted output Y(n) at time n, represented mathematically as:

$$Y(n) = \sum_{i=1}^{m} C_n(i)X(n-i) \qquad (1)$$

where i = 1, 2,...,m,
Y(n) is the predicted output at time n,
$C_n(i)$ is the i-th filter coefficient at time n, and
X(n-i) is the (n-i)-th sample at time n.

Each of the sample values X(n-i) in the FIFO stack 50 at time n is squared in a power calculator 54, as represented by each sample being multiplied via multiplying devices 62 by itself and summed in a summing device 66 to generate the power of the stack 50. The stack power is represented mathematically at time n as:

$$P(n) = \sum_{i=1}^{m} X^2(n-i) \qquad (2)$$

In terms of computing the stack power, there is no need to recompute the entire stack power at every time sample because only the first and the last samples in the stack 50 have changed. Accordingly, in the preferred embodiment, computational time is reduced by computing the stack power, at time n according to

$$P(n) = P(n-1) - X^2(n-m) + X^2(n) \qquad (3)$$

The power of the oldest signal sample X(n-m) is removed while that of the most current sample X(n) is added.

The energy of the stack at time n is calculated by multiplying the power P(n) by the number of samples m in the stack using a multiplying device 68, such that

$$E(n) = P(n) \cdot m. \qquad (4)$$

The energy of the stack samples plays an important role in the adaption of the filter coefficients. The filter coefficients ($C_1$, $C_2$,...$C_m$) are updated in a filter coefficient update block 70. The filter coefficients are updated at time n in accordance with the equation

$$C_{n+1}(i) = C_n(i) - e(n)X(n-i)G(n); \qquad (5)$$

where i = 1, 2..., m,
$C_n(i)$ is the i-th filter coefficient at time n,
e(n) is the sampled residual error at time n,
X(n-i) is the (n-i)-th sample value at time n, and
G(n) = k/E(n), where k is a constant and E(n) is the stack energy. The constant k is application dependent and falls within the range 0 < k < 1. The value of k in the preferred embodiment is 0.50.

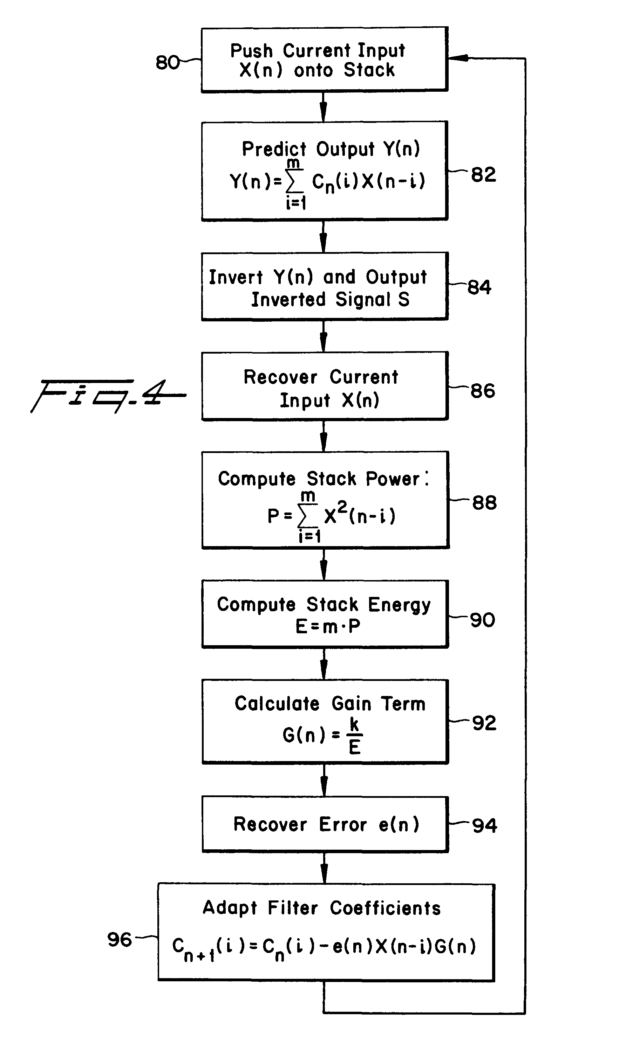

As mentioned above, the calculations performed in the adaptive filter 28 can be readily implemented using a conventional microprocessor. The program flow or control followed by such a microprocessor is illustrated in Fig. 4. Initially, the current input X(n) at time n is pushed onto the FIFO stack 50 as indicated in the function block 80. From the function block 80, program flow proceeds to the function block 82 where the predicted output Y(n) is predicted based on the equation (1):

$$Y(n) = \Sigma^m_{i=1} C_n(i)X(n-i).$$

In the function block 84, the predicted output Y(n) is inverted to generate a predicted output signal S, such that S = -Y(n). The output signal S is defined as the inverse signal. Program flow proceeds to the function block 86, where the current input X(n) is recovered and used to compute the power of the FIFO stack 50 in the function block 88 in accordance with the equation (2)

$$P(n) = \Sigma^m_{i=1} X^2(n-i).$$

The program flow proceeds to the function block 90 where the energy of the FIFO stack 50 is computed in accordance with the equation (4)

E(n) = P(n)$\bullet$m.

In the function block 92, the gain coefficient term G(n) is calculated in accordance with the equation

G(n) = k/E(n).     (6)

In the function block 94, the residual error e(n) is determined from the algebraic sum of the signal to be cancelled and the inverse signal S. Program flow proceeds to the function block 96 where the filter coefficients 62 are adapted in accordance with the equation (5)

$C_{n+1}(i) = C_n(i) - e(n)X(n-i)G(n)$.

Because this is an ongoing predictive process, once the filter coefficients have been adapted for a time n, the program control returns to the function block 80 to push the next signal sample, e.g. at time n + 1, onto the FIFO stack 50.

In operation, the present invention is capable of predicting a signal in real time. As described above, one area of application relates to the modification or cancellation of such signals as acoustic noise or vibration. Other applications could include: cancellation of electrical line noise and RF noise, monitoring of a known signal to detect abnormalities that might be caused by the presence of secondary or external sources so that alarms and warning signals could be triggered, and modification or some combined cancellation and modification of a signal in order to change the character of the residual error signal.

In real time signal cancellation or modification applications, a modifying or cancelling signal is determined prior to the next sampling of the time varying signal. Because of the simplicity in the mathematical calculations used in the present invention, real time operation is achieved at very high sampling rates. Thus, the present invention may be applied not only to electrical signals generated from captured signals in the voice recognition or audible frequency bands, but may also be applied to other electrical signals generated from captured signals in the infrasonic, ultrasonic, electrical and radio frequency bands which are sampled according to the requirements of the preferred embodiment of the present invention. Moreover, operation in the time domain, as opposed to a select number of frequencies in the frequency domain, allows for a more accurate prediction and cancellation of a time varying signal.

The adaptive qualities of the present invention allow aperiodic signals to be predicted in real time. Premodelling of the signal to be cancelled is not required, allowing for a flexibility and adaptability in a wide range of applications. In addition, the timing or pulse generators and the synchronization procedures used in the prior art systems to synchronize the generation of the premodelled signal with the sensed signal are completely unnecessary.

With respect to updating adaptive filters, the prior art systems update the filter coefficients assuming that the gain coefficient G(n) in equation (4) applied to the coefficients at time n is always a constant. Accordingly, the prior art filters are adapted only as a function of the residual error and a constant filter gain coefficient. Because the gain coefficient is a constant, the filter coefficients are always updated by the same gain regardless of whether it is appropriate for the amount of correction needed in a particular situation. This increases the adaptation time, and hence, reduces the effectiveness of the filter.

The updating of coefficients in the present invention is a function of the residual error and a <u>dynamic</u>

gain G(n). In other words, the gain coefficient G(n) changes according to the amplitudes of the signal samples in the FIFO stack 50 being used to predict the next sample value. By updating the gain coefficient G(n) based on the power P(n) in the FIFO stack 50 for each sample period, the magnitude of the gain is appropriate to the amount of correction actually required. The normalization of the gain coefficient results in a more stable filter performance over the dynamic range of the system. The prior art use of a constant, application-specific gain G emphasizes large errors, causing the filter to overadapt when presented with signals varying rapidly in amplitude. Thus, the adaptation time of the adaptive filter 28 to accurately predict the sensed signal is significantly reduced.

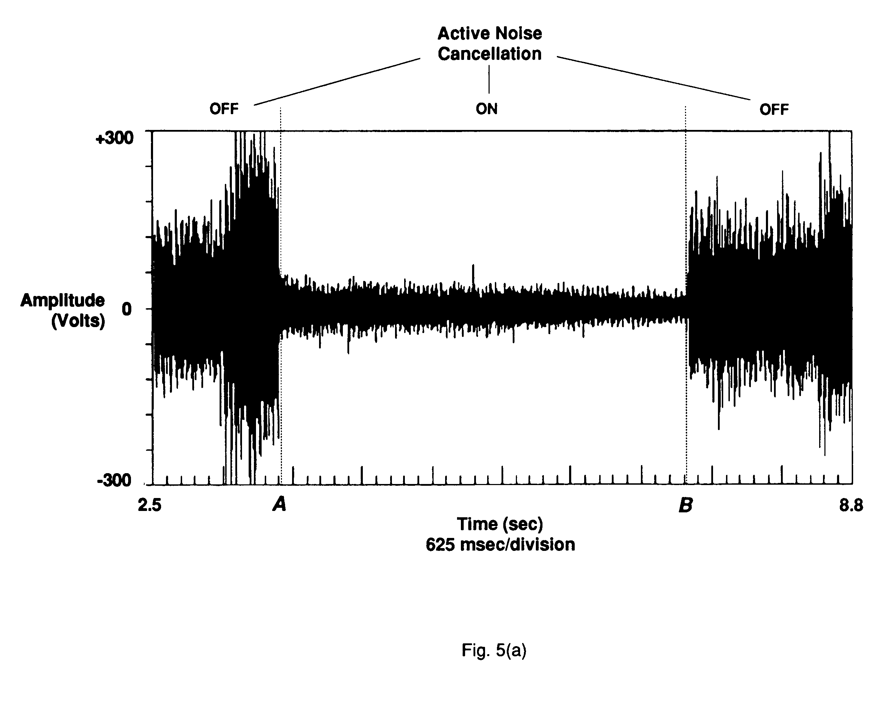

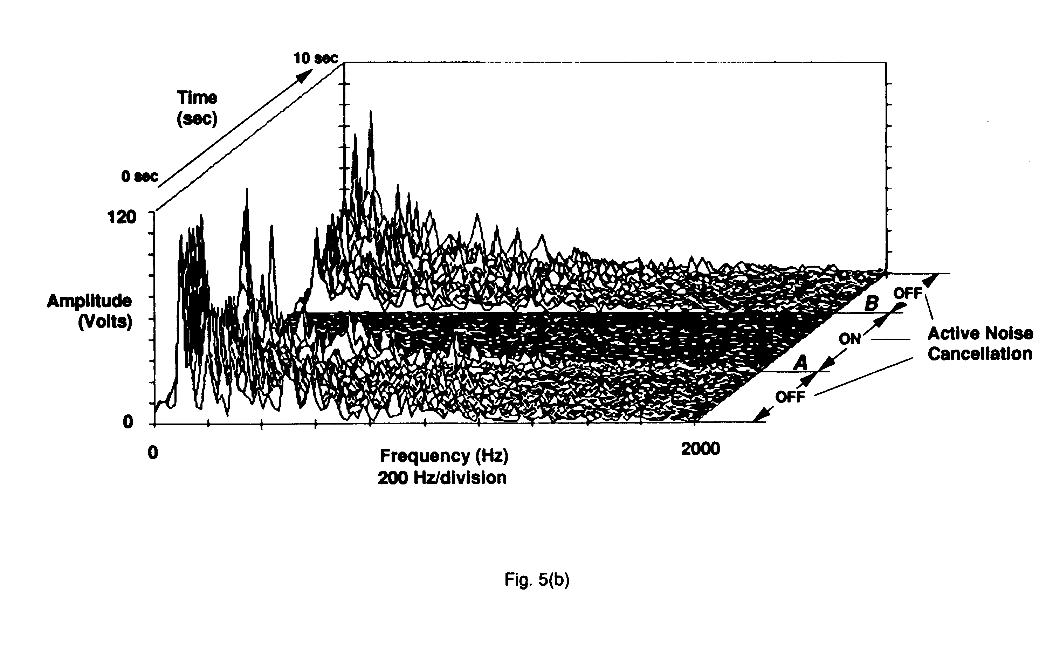

One practical application of the present invention might be to predict and cancel signals generated by a petrol-powered lawn mower. The signal graph shown in Fig. 5(a) plots the amplitude of the lawnmower output signal in volts against time in msec. At a sampling frequency of 43.86 kHz, the overall acoustic signature is about 93 dBA. When the signal cancellation system according to the present invention is activated at time A, as shown in Fig. 5(a), the amplitude of the residual noise caused by the lawnmower is reduced, for the most part, to an amplitude of about 73 dBA in approximately 5 milliseconds after the prediction and cancellation process was initiated. Thereafter, the adaptive system is able to track the noise signal despite aperiodic amplitude and frequency changes, e.g., manual changes in the throttle mechanism of the lawnmower, in real time. For comparison purposes, the signal cancellation system is deactivated at time B. From this graph, it is evident that in a very short time period, a noise cancellation system implementing the present invention predicted in real time an unknown, aperiodic signal having a broad band frequency spectrum, and provided a cancellation signal that effectively reduced the lawnmower noise level by 20db in 0.005 seconds.

A three-dimensional graphic of this same example is shown in Fig. 5(b). Fig. 5(b) depicts how the lawn mower frequency and amplitude characteristics vary with respect to time when the active noise cancellation system is activated, and then at a later time deactivated. Accordingly, it can be seen from the graph that the present invention predicts and cancels signals not only very quickly with respect to time but also comprehensively across the frequency spectrum of the noise signal. In other words, the present invention is not limited to cancelling a few, previously identified frequency components. Rather, a cancellation system in accordance with the present invention is able to predict and cancel signals in the broadband frequency spectrum in real time.

The invention has been described in terms of specific embodiments to facilitate understanding. The above embodiments, however, are illustrative rather than limitative. It will be readily apparent to one of ordinary skill in the art that departures may be made from the specific embodiments shown above without departing from the essential scope of the invention as defined in the following claims.

## Claims

1. Apparatus for predicting time varying signals in real time, comprising:

   sampling means for successively sampling a time varying signal;

   predicting means for predicting a predicted signal at a first time based on the sum of a first, predetermined number of signal samples stored at a second time occurring earlier than said first time, each of said stored samples being multiplied by one of a plurality of corresponding weights;

   error detecting means for detecting a residual error based on the sum of said time varying signal and said predicted signal; and

   adaptive gain means for adapting said weights applied to a second, predetermined number of signal samples stored at said first time for predicting a subsequent, predicted signal at a third time occurring after said first time based on said residual error and the energy of said first, predetermined number of samples stored at said first time, wherein said system is capable of predicting periodic and/or aperiodic signals.

2. Apparatus as claimed in claim 1, further comprising:

   first-in-first-out (FIFO) memory means for storing said predetermined number of samples.

3. Apparatus as claimed in claim 2, wherein said energy is based on the power of the samples stored in said FIFO memory means.

4. Apparatus as claimed in claim 1, 2 or 3 further comprising:

   a sensing means for sensing said periodic and aperiodic signals.

5. Apparatus as claimed in claim 4, further comprising:
signal conditioning means for amplifying and filtering said sensed signal.

6. Apparatus as claimed in claim 5, wherein said signal conditioning means is an operational amplifier.

7. Apparatus as claimed in any preceding claim wherein said sampling means is an analog-to-digital converter.

8. Apparatus as claimed in any preceding claim further comprising:
inversion means for inverting the amplitude of said predicted signal and generating an inverted signal;
digital-to-analog conversion means for converting said inverted signal to an analog drive signal; and
transducer means for receiving said drive signal and outputting a modification signal for modifying said sensed signal.

9. Apparatus for providing a cancelling signal based on a current sampling of signals and outputting said cancelling signal prior to the sampling of a next, successive signal, comprising:
filtering means for filtering frequency components of a signal to be cancelled above a predetermined frequency;
sampling means for successively sampling said filtered signal;
predicting means for predicting a next, successive predicted signal at time (n + 1) for cancelling said signal to be cancelled based on the sum of m stored samples stored at time n, each of said m stored samples being multiplied by a corresponding one of m weights;
error detecting means for detecting a residual error based on the sum of said signal to be cancelled and said predicted signal; and
adaptive gain means for adapting said m weights applied to a successive set of m stored samples stored at time (n + 1) for predicting a next, successive predicted signal at time (n + 2) based on said residual error and the energy of said successive m samples stored at time (n + 1), wherein said system is capable of cancelling broadband periodic and/or aperiodic signals.

10. Apparatus as claimed in claim 9, further comprising:
detecting means for detecting said signal to be cancelled;
first-in-first-out (FIFO) memory means, connected to said sampling means, for storing said m successive samples;
amplitude inversion means, connected to said predicting means, for inverting the amplitude of said predicted signal; and
output means, connected to said inversion means, for outputting said cancelling signal based on said inverted signal.

11. Apparatus as claimed in claim 10, wherein said sampling means is an analog-to-digital converter, said detecting means is a microphone, and said output means is a loudspeaker.

12. Apparatus as claimed in claim 9, 10 or 11 wherein said adaptive gain means determines the energy of said successive m samples based on the product of the sum of the squares of each of said m samples and the number of stored samples m.

13. Apparatus as claimed in claim 12, wherein said energy is calculated using the following:
$E(n) = m[P(n) - X^2(n-m) + X^2(n)]$; where
m represents the total number of samples,
X(n-m) represents the oldest sample of the signal,
X(n) represents the most current sample of the signal

$$P(n) = \sum_{i=1}^{m} X^2(n-i),$$

P(n) represents the power of the m samples at time n, and
E(n) represents the energy of the m samples at time n.

8

**14.** Apparatus as claimed in claim 13, wherein said weights are adapted in accordance with the following:
$C_{n+1}(i) = C_n(i) - e(n) X(n-i) G(n)$; where at time n,
$C_n(i)$ is the i-th filter coefficient, at time n,
$i = 0, 1, 2,...m$,
$e(n)$ is the residual error,
$X(n-i)$ is the (n-i)-th signal sample,
$C(n) = k/E(n)$, k being a constant such that $0 < k < 1$.

**15.** Apparatus as claimed in any of claims 9 to 14, wherein said signal to be cancelled includes broadband periodic and/or aperiodic signals.

**16.** Apparatus as claimed in claim 15, wherein said signal to be cancelled is in the audible frequency band.

**17.** Apparatus as claimed in claim 15, wherein said signal to be cancelled is in the voice recognition frequency band.

**18.** Apparatus as claimed in any of claims 9 to 17, wherein said sampling means samples said filtered signal at a rate five times higher than said predetermined frequency.

**19.** A method of predicting time varying signals in real time, comprising:
sampling a time varying signal;
predicting a successive predicted signal at time (n + 1) based on the sum of a first, predetermined number of signal samples stored at time n, each of said m stored samples being multiplied by a corresponding one of m weights;
detecting a residual error based on a combination of said time varying signal and said predicted signal; and
adapting said m weights applied to a successive set of m stored samples stored at time (n + 1) based on said residual error and the energy of said successive m samples stored at time (n + 1); and
predicting a next, successive predicted signal at time (n + 2);
wherein said method is capable of predicting broadband periodic and/or aperiodic signals.

**20.** A method as claimed in claim 19, wherein said time varying signal is a signal to be cancelled, further comprising:
filtering frequency components of said signal to be cancelled above a predetermined frequency before said sampling step.

**21.** A method as claimed in claim 19 or 20, wherein said adapting step includes:
determining said energy of said successive m samples based on the product of the sum of the squares of each of said m samples and the number of stored samples m.

## Fig.1(a)
### PRIOR ART

10 — Noise or Vibration Disturbance

a → Σ 18 → c → Summation

b

12 — Sensor

16 — Actuator

Cancellation Signal

Controller

14

## Fig.1(b)
### PRIOR ART

a

b

c

Time →

Fig. 2

EP 0 466 989 A2

Fig.3

EP 0 466 989 A2

$$Fig. 4$$

| | |
|---|---|
| 80 | Push Current Input X(n) onto Stack |

$$Y(n) = \sum_{i=1}^{m} C_n(i) X(n-i)$$

Predict Output Y(n) — 82

Invert Y(n) and Output Inverted Signal S — 84

Recover Current Input X(n) — 86

Compute Stack Power:
$$P = \sum_{i=1}^{m} X^2(n-i)$$
— 88

Compute Stack Energy
$$E = m \cdot P$$
— 90

Calculate Gain Term
$$G(n) = \frac{k}{E}$$
— 92

Recover Error e(n) — 94

Adapt Filter Coefficients
$$C_{n+1}(i) = C_n(i) - e(n) X(n-i) G(n)$$
— 96

13

Fig. 5(a)

EP 0 466 989 A2

Fig. 5(b)

EP 0 466 989 A2